(19) Europäisches Patentamt
European Patent Office
Office européen des brevets

(11) **EP 2 446 536 B1**

(12) **EUROPÄISCHE PATENTSCHRIFT**

(45) Veröffentlichungstag und Bekanntmachung des Hinweises auf die Patenterteilung:
**29.08.2018 Patentblatt 2018/35**

(21) Anmeldenummer: **10721471.0**

(22) Anmeldetag: **17.05.2010**

(51) Int Cl.:
**H03K 17/082** $^{(2006.01)}$

(86) Internationale Anmeldenummer:
**PCT/EP2010/056682**

(87) Internationale Veröffentlichungsnummer:
**WO 2010/149430 (29.12.2010 Gazette 2010/52)**

(54) **KOMMUTIERUNGSVERFAHREN EINER STROMRICHTERPHASE MIT RÜCKWÄRTS LEITFÄHIGEN IGBTS**

COMMUTATION METHOD OF AN ELECTRONIC POWER CONVERTER PHASE WITH REVERSE-CONDUCTING IGBTS

PROCÉDÉ DE COMMUTATION D'UNE PHASE DE CONVERTISSEUR ÉLECTRONIQUE DE PUISSANCE CONSTITUÉE DE TRANSISTORS IGBT À CONDUCTION INVERSE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **26.06.2009 DE 102009030740**

(43) Veröffentlichungstag der Anmeldung:
**02.05.2012 Patentblatt 2012/18**

(73) Patentinhaber: **Siemens Aktiengesellschaft 80333 München (DE)**

(72) Erfinder: **ECKEL, Hans-Günter 18059 Rostock (DE)**

(56) Entgegenhaltungen:
**WO-A1-02/21691          WO-A2-02/41085
US-A1- 2003 001 630    US-A1- 2004 196 678**

**Beschreibung**

Die Erfindung bezieht sich auf ein Verfahren zur Kommutierung von einem im Dioden-Modus betriebenen rückwärts leitfähigen IGBT auf einen im IGBT-Modus betriebenen rückwärts leitfähigen IGBT, die eine Stromrichterphase bilden und elektrisch parallel zu einer Gleichspannungsquelle geschaltet sind, mit den Verfahrensschritten gemäß Oberbegriff des Anspruchs 1. Außerdem bezieht sich die Erfindung auf eine Vorrichtung zur Durchführung des erfindungsgemäßen Verfahrens.

Rückwärts leitfähige IGBTs sind auch als **R**everse-**C**onducting IGBTs (RC-IGBT) bekannt. Diese RC-IGBTs sind eine Weiterentwicklung der bekannten rückwärts sperrfähigen IGBTs. Ein RC-IGBT unterscheidet sich von einem herkömmlichen IGBT dadurch, dass die Diodenfunktion und die IGBT-Funktion in einem Chip vereinigt sind. Dadurch entsteht ein Leistungshalbleiter, bei dem die Anodeneffizenz im Dioden-Modus von der Gate-Spannung abhängig ist. Dies verlangt nach Änderung in der Ansteuerung gegenüber herkömmlichen IGBTs.

Bei rückswärts leitfähigen IGBTs lässt sich die Anordeneffizenz im Dioden-Modus durch das Gate steuern. Ist das Gate eingeschaltet, reduziert sich die Anordeneffizenz, wogegen die Durchlassspannung steigt und die Speicherladung sinkt. Ist dagegen das Gate ausgeschaltet, so bleibt die Anordeneffizenz hoch, wodurch die Durchlassspannung niedrig und die Speicherladung hoch ist.

Dieses Verhalten des rückwärts leitfähigen IGBTs lässt sich nutzen, um die Reverse-Recovery-Verluste des im Dioden-Modus betriebenen rückwärts leitfähigen IGBT und die Einschaltverluste des zweiten rückwärts leitfähigen IGBT einer Stromrichterphase zu reduzieren.

In der Veröffentlichung "A High Current 3300V Module Employing Reverse Conducting IGBTs Setting a New Benchmark in Output Power Capability" von M. Rahimo, U. Schlapbach, A. Kopta, J. Vobecky, D. Schneider und A. Baschnagel, abgedruckt in ISPSD 2008 wird ein Verfahren zur Kommutierung von einem im Dioden-Modus betriebenen rückwärts leitfähigen IGBT auf einen im IGBT-Modus betriebenen rückwärts leitfähigen IGBT bschrieben. Gemäß diesem bekannten Verfahren wird ein im Dioden-Modus betriebener IGBT nach Ablauf einer vorbestimmten ersten Verzögerungszeit, beginnend vom Zeitpunkt eines Soll-Ausschalt-Steuersignals eingeschaltet. Der im IGBT-Modus betriebene IGBT der beiden in Reihe geschalteten RC-IGBTs wird nach Ablauf einer vorbestimmten zweiten Verzögerungszeit, beginnend vom Zeitpunkt eines Soll-Einschalt-Steuersignals eingeschaltet. Unmittelbar vor dem Einschalten des im IGBT-Modus betriebenen RC-IGBTs wird der im Dioden-Modus betriebene RC-IGBT wieder ausgeschaltet. Dazu ist eine Zeitspanne für den im Dioden-Modus betriebenen RC-IGBT vorgegeben, während dieser rückwärts leitfähige IGBT eingeschaltet bleibt.

Nachteil dieses bekannten Verfahrens ist die Empfindlichkeit gegenüber schlecht tolerierten Laufzeiten. Einerseits muss die Gatespannung vom im Dioden-Modus betriebenen rückwärts leitfähigen IGBT unter einer Schwellen-Spannung, die sogenannte Threshold-Spannung, abgesenkt sein, bevor eine Rückstromspitze vom im Dioden-Modus betriebenen rückwärts leitfähigen IGBT erreicht ist. Andererseits darf der im Dioden-Modus betriebene rückwärts leitfähige IGBT beim Einschalten des im IGBT-Modus betriebenen rückwärts leitfähigen IGBT noch nicht lange abgeschaltet sein, weil sonst der Effekt der Anodeneffizienz-Absenkung nicht mehr wirkt. Die Signalwege von einer übergeordneten Steuereinrichtung, beispielsweise einer Steuereinrichtung eines Stromrichters, zu den Ansteuerschaltungen, auch als Treiberschaltungen bezeichnet, der beiden elektrisch in Reihe geschalteten RC-IGBTs weisen jedoch jeweils eine Potentialtrennung auf. Dies führt zu relativ großen Toleranzen in den Schaltzeiten, durch die Toleranzen in den Ansteuerpfaden der elektrisch in Reihe geschalteten RC-IGBTs noch vergrößert werden. Somit bedingt die Einschaltung der aufeinander abgestimmten Verzögerungszeiten einen großen Aufwand.

Der Erfindung liegt somit die Aufgabe zugrunde, das bekannte Verfahren derart weiter zu gestalten, dass es weniger empfindlich auf schlecht tolerierte Laufzeiten ist.

Diese Aufgabe wird in Verbindung mit den Merkmalen des Oberbegriffs des Anspruchs 1 mit den kennzeichnenden Merkmalen erfindungsgemäß gelöst.

Somit erfolgt die Abschaltung des Gates des im Dioden-Modus betriebenen rückwärts leitfähigen IGBT nicht mehr zeitgesteuert, sondern ereignisgesteuert. Gemäß dem erfindungsgemäßen Verfahren wird als Ereignis der Beginn eines Stromflusses durch einen im IGBT-Modus betriebenen rückwärts leitfähigen IGBT gewählt.

Diesen Zeitpunkt des Stromflusses durch den im IGBT-Modus betriebenen rückwärts leitfähigen IGBT wird in einer ersten Ausführungsform mittels einer an einer Induktivität abfallenden Spannung ermittelt, wobei diese Induktivität im Kommutierungskreis angeordnet ist. Die Stromsteilheit im Kommutierungskreis ist um mindestens einer Zehnerpotenz größer als in einem zugeordneten Lastkreis. Dadurch kann der Beginn der Kommutierung am induktiven Spannungsabfall eindeutig ohne großen Aufwand ermittelt werden. Die Kommutierung führt somit zu einer hohen positiven Stromänderung ($di_C/dt$) und damit zu einem betragsmäßig hohen negativen Spannungswert an der Induktivität, die als Messspannung verwendet wird. Der Verlauf dieser Messspannung wird hinsichtlich eines vorbestimmten Grenzwertes ausgewertet, wobei eine nachgeschaltete Treiberschaltung angesteuert wird, sobald dieser Grenzwert erreicht bzw. überschritten wird.

Eine vorteilhafte Ausführungsform der Vorrichtung zur Erfassung des Zeitpunktes des Stromflusses im im IGBT-Modus betriebenen rückwärts leitfähigen IGBT ist eine Streuinduktivität innerhalb des RC-IGBT-Moduls, die zwischen Hilfsemitter und Leistungsemitter angeordnet ist. Diese Streuinduktivität ist elektrisch parallel zu den beiden Eingängen einer Auswerteeinrichtung geschaltet.

Eine weitere Möglichkeit der Erfassung des Zeitpunktes des Stromflusses im im IGBT-Modus betriebenen RC-IGBT besteht darin, dass der Kollektorstrom des im Dioden-Modus betriebenen RC-IGBT gemessen wird. Eine besonders günstige Realisierung einer Strommessung besteht darin, dass ein Stromwandler, der nach dem Rogowsky-Spulen-Prinzip aufgebaut ist, eingesetzt wird. Das Ausgangssignal eines nach dem Rogowsky-Spulen-Prinzip aufgebauten Stromwandlers ist proportional zur Stromänderung ($di_C/dt$) und somit wie bei der Verwendung einer Induktivität im Kommutierungs-kreis einfach auszuwerten.

Bei einer weiteren Möglichkeit der Erfassung des Zeitpunktes des Stromflusses im im IGBT-Modus betriebenen RC-IGBT wird die Stromerfassung mittels eines sättigbaren Übertragers ausgeführt. Mittels eines solchen Übertragers wird ein Nulldurchgang des Kollektorstromes durch den im Dioden-Modus betriebenen IGBT ermittelt. Ein sättigbarer Übertrager liefert nur dann ein Ausgangssignal, wenn sich die magnetische Feldstärke im schmalen linearen Bereich der Magnetisierungskennlinie befindet. Dadurch erfolgt die Entladung des Gates des im Dioden-Modus betriebenen rückwärts leitfähigen IGBT nicht zu Beginn des Kommutierungsvorgangs, sondern erst beim Nulldurchgang des Kollektorstromes, also zu Beginn des Reverse-Recovery-Stromes.

Zur weiteren Erläuterung der Erfindung wird auf die Zeichnung Bezug genommen, in der mehrere Ausführungsformen einer Vorrichtung zur Durchführung des erfindungsgemäßen Verfahrens schematisch veranschaulicht sind.

FIG 1      zeigt ein Blockschaltbild eines Brückenzweiges zweier RC-IGBTs mit einer Gleichspannungsquelle, in den

FIG 2 und 3      sind die zeitlichen Verläufe von Soll-Steuersignalen der beiden RC-IGBTs des Brückenzweiges gemäß FIG 1 jeweils in einem Diagramm über der Zeit t dargestellt, in den

FIG 4 und 5      sind die zeitlichen Verläufe der Ist-Steuersignale der beiden RC-IGBTs des Brückenzweiges gemäß FIG 1 jeweils in einem der beiden Diagramm über der Zeit t veranschaulicht, in der

FIG 6      ist ein Blockschaltbild einer ersten Ausführungsform der Vorrichtung zur Durchführung des Kommutierungsverfahrens nach der Erfindung dargestelltung, die

FIG 7      zeigt ein Blockschaltbild einer zweiten Ausführungsform der Vorrichtung zur Durchführung des Kommutierungsverfahrens nach der Erfindung, in der

FIG 8      sind in einem Diagramm über der Zeit t ein Kollektorstrom und eine zugehörige Messspannung dargestellt, die

FIG 9      zeigt ein Blockschaltbild einer dritten Ausführungsform der Vorrichtung zur Durchführung des Kommutierungsverfahrens nach der Erfindung, wobei in der

FIG 10      eine Magnetisierungskennlinie eines sättigbaren Übertragers dargestellt ist, und die

FIG 11      zeigt in einem Diagramm über der Zeit t einen Kollektorstrom mit zugehöriger Messspannung.

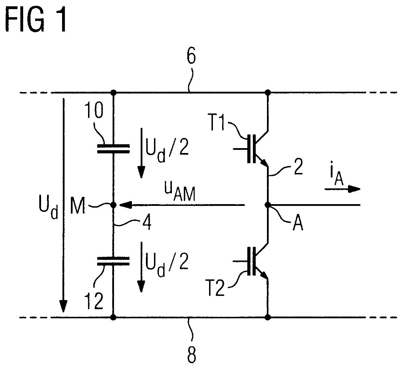

In der FIG 1 sind mit 2 ein Brückenzweig, mit 4 eine Gleichspannungsquelle, mit 6 eine positive Stromschiene und mit 8 eine negative Stromschiene bezeichnet. Mittels dieser beiden Stromschienen 6 und 8 sind der Brückenzweig 2 und die Gleichspannungsquelle 4 elektrisch parallel geschaltet. Der Brückenzweig weist zwei rückwärts leitfähige IGBTs T1 und T2 auf, die elektrisch in Reihe geschaltet sind. Ein Verbindungspunkt dieser beiden RC-IGBTs T1 und T2 bilden einen wechselspannungsseitigen Ausgang A, an dem eine Last anschließbar ist. Die Gleichspannungsquelle 4 weist zwei Kondensatoren 10 und 12 auf, die ebenfalls elektrisch in Reihe geschaltet sind. Ein Verbindungspunkt dieser beiden Kondensatoren 10 und 12 bildet einen Mittelpunkt-Anschluss M. Alternativ kann statt der beiden Kondensatoren 10 und 12 auch nur ein Kondensator verwendet werden, der zwischen den Stromschienen 6 und 8 angeordnet ist. Der Mittelpunkt M ist dann nicht zugänglich. Am Ausgang A des Brückenzweiges 2 steht bezogen auf den Mittelpunkt-Anschluss M der Gleichspannungsquelle 4 eine pulsweitenmodulierte Rechteckspannung $u_{AM}$ an. Ein in der FIG 1 dargestelltes Blockschaltbild entspricht einem Teil eines Blockschaltbildes eines mehrphasigen Stromrichters, insbesondere eines Wechselrichters.

Da die Dioden-Funktion und die IGBT-Funktion in einem Chip vereinigt sind, wird beim rückwärts leitfähigen IGBT T1 und T2 keine Freilauf-Diode bzw. keine Invers-Diode benötigt. Diese IGBTs werden wegen ihrer Rückwärtsleitfähigkeit auch als RC-IGBT (**R**everse **Co**nducting-**I**nsulated **G**ate **B**ipolar **T**ransistor) bezeichnet. Da in einem Chip die Dioden- und IGBT-Funktionalität vereint sind, kann dieser RC-IGBT im Dioden-Modus (negativer Kollektor-Emitter-Strom) und im IGBT-Modus (positiver Kollektor-Emitter-Strom) betrieben werden. Im Dioden-Modus lässt sich die Anodeneffizienz durch das Gate steuern. Ist das Gate eingeschaltet, reduziert sich die Anodeneffizienz und damit steigt die Durchlassspannung, wogegen die Speicherladung sinkt. Ist das Gate ausgeschaltet, so bleibt die Anodeneffizienz hoch. Dies hat zur Folge, dass die Durchlassverluste niedrig und die Speicherladung hoch sind.

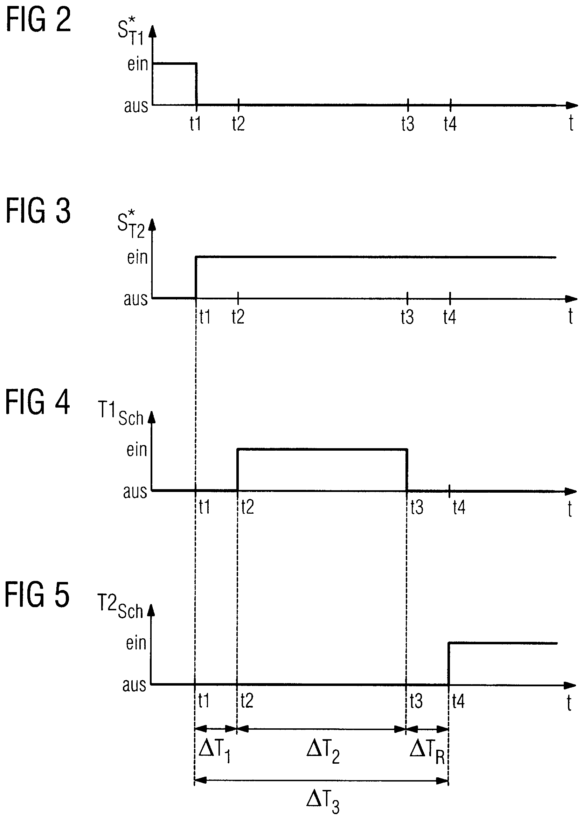

Bei den Signalverläufen der Figuren 2 bis 5 wird angenommen, dass der rückwärts leitfähige IGBT T1 im Dioden-Modus und der rückwärts leitfähige IGBT T2 im IGBT-Modus betrieben werden. Im Diagramm der FIG 2 ist über Zeit t ein Soll-Steuersignal $S_{T1}^*$ für den im Dioden-Modus betriebenen RC-IGBT T1 dargestellt, wogegen ein Soll-Steuersignal $S_{T2}^*$ für den im IGBT-Modus betriebene RC-IGBT T2 im Diagramm der FIG 3 über der Zeit t veranschaulicht ist. Diese beiden Soll-Steuersignale $S_{T1}^*$ und $S_{T2}^*$ kennzeichnet einen Kommutierungsvorgang zum Zeitpunkt t1. Ausgehend von diesem Zeitpunkt t1 wird nach Ablauf einer Zeitspanne $\Delta T1$ der in Dioden-Modus betriebene rückwärts leitfähige IGBT T1 eingeschaltet (FIG 4). Der im IGBT-Modus betriebene rückwärts leitfähige IGBT T2 wird gemäß dem zeitlichen Verlauf des Schaltzustandes $T2_{Sch}$ gemäß FIG 5 nach Ablauf auf einer Zeitspanne $\Delta T3$ ausgehend vom Zeitpunkt t1 eingeschaltet (Zeitpunkt t4). Zum Zeitpunkt t4 muss der im Dioden-Modus betriebene rückwärts leitfähige IGBT T2 gemäß dem zeitlichen Verlauf des Schaltzustandes $T1_{Sch}$ gemäß FIG 4 ausgeschaltet sein. Andererseits darf der im Dioden-Modus betriebene rückwärts leitfähige IGBT T1 noch nicht lange abgeschaltet sein, weil sonst der Effekt der Anodeneffizienz-Absenkung nicht mehr wirkt. D.h., dass die Zeitspanne $\Delta T_R$ zwischen Ausschalten des im Dioden-Modus betriebenen RC-IGBTs T1 und dem Einschalten des im IGBT-Modus betriebenen RC-IGBTs T2 möglichst klein sein sollte. In Abhängigkeit der Zeitspanne $\Delta T_1$ und der Zeitspanne $\Delta T_R$ bezogen auf die Zeitspanne $\Delta T_3$ ergibt sich die Zeitspanne $\Delta T_2$, während der der im Dioden-Modus betriebene IGBT T1 eingeschaltet ist.

Gemäß der eingangs genannten Veröffentlichung ist diese Kommutierung zweier rückwärts leitfähiger IGBTs T1 und T2 einer Stromrichterphase zeitgesteuert. Diese zeitgesteuerte Kommutierung erfordert eine hohe zeitliche Präzision. Um bei dieser zeitgesteuerten Kommutierung auf der sicheren Seite zu sein, wird die Zeitspanne $\Delta T_R$ so groß gewählt, dass zum Einschaltzeitpunkt t4 des im IGBT-Modus betriebenen rückwärts leitfähigen IGBT T2 der im Dioden-Modus betriebene rückwärts leitfähige IGBT T1 zweier elektrisch in Reihe geschalteter RC-IGBTs T1 und T2 sicher ausgeschaltet ist. Da im Signalweg von einer Steuereinrichtung zu einer Ansteuerschaltung des RC-IGBTs T1 bzw. T2 Bauelemente vorhanden sind, die relativ große Toleranzen unterworfen sind, muss die Zeitspanne $\Delta T_R$ noch größer gewählt werden.

Gemäß dem erfindungsgemäßen Verfahren erfolgt diese in den Diagrammen der Figuren 2 bis 5 dargestellte Kommutierung nicht mehr zeitgesteuert, sondern ereignisgesteuert. Als Ereignis wird der Beginn des Stromflusses durch den im IGBT-Modus betriebenen RC-IGBT T2 gewählt. Dieses Ereignis wird aber am im Dioden-Modus betriebenen RC-IGBT T1 bestimmt.

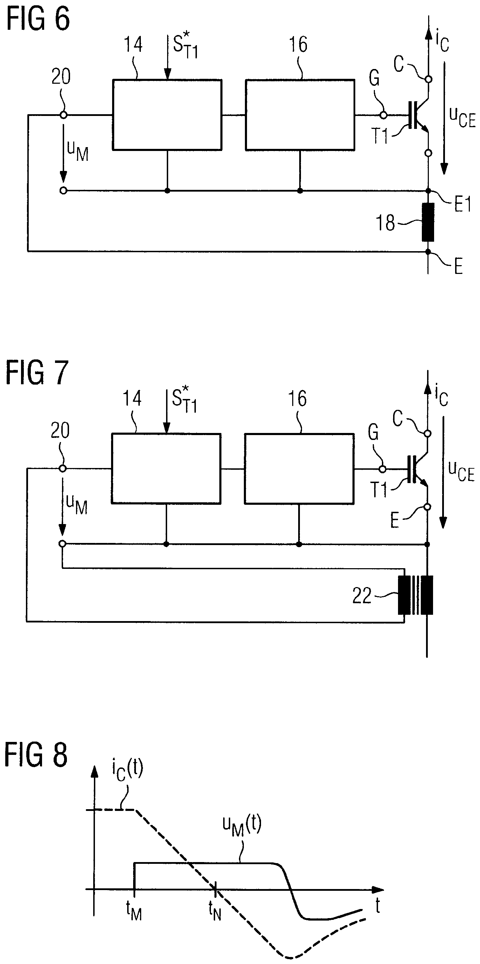

In der FIG 6 ist eine erste Ausführungsform einer Vorrichtung zur Durchführung des Kommutierungsverfahrens nach der Erfindung schematisch veranschaulicht. Diese Vorrichtung weist eine Auswerteeinrichtung 14 auf, die ausgangsseitig mit einem Eingang einer Ansteuerschaltung 16, die auch als Treiberschalter bezeichnet wird, verknüpft ist. Diese Vorrichtung weist ebenfalls eine Einrichtung zur Erfassung einer Ableitung nach der Zeit des Kollektorstromes $i_C$ durch den im Dioden-Modus betriebenen RC-IGBT T1 auf. D.h., es wird die Stromänderung des Kollektorstromes $i_C$ ermittelt. In der Ausführungsform gemäß FIG 6 ist als Einrichtung eine Induktivität 18, insbesondere eine modulinterne Streuinduktivität, vorgesehen. Handelt es sich bei der Einrichtung um eine modulinterne Streuinduktivität 18, so befindet sich diese Induktivität 18 im IGBT-Modul zwischen einem Hilfsemitter E1 und einem Emitter-Anschluss E. Handelt es sich um eine Induktivität 18, ist diese einseitig mit dem Emitter-Anschluss E verknüpft. In der FIG 6 dargestellten Ausführungsform bildet der Emitter E1 ein Bezugspotential für die Auswerteeinrichtung 14 und für die Treiberschaltung 16. Der Emitter-Anschluss E des im Dioden-Modus betriebenen RC-IGBT T1 zweier elektrisch in Reihe geschalteter RC-IGBTs T1 und T2 ist mit einem Eingang 20 der Auswerteeinrichtung 14 elektrisch leitend verbunden. Der Auswerteeinrichtung 14 ist ebenfalls das Soll-Steuersignal $S_{T1}^*$ zugeführt.

Da die Stromsteilheit im Kommutierungskreis um mindestens einer Zehnerpotenz größer ist als eine im Laststromkreis, kann der Beginn des Stromflusses durch den im IGBT-Modus betriebenen RC-IGBT T2 am Spannungsabfall an der Induktivität 18 des im Dioden-Modus betriebenen RC-IGBT T1 klar erkannt werden.

Die Kommutierung des Kollektorstromes $i_C$ vom im Dioden-Modus betriebenen RC-IGBT T1 auf den im IGBT-Modus betriebenen RC-IGBT T2 führt zu einer hohen positiven Stromänderung $di_C/dt$ und somit zu einem betragsmäßig hohen negativen Wert einer Messspannung $u_M$. Dieser Wert der Messspannung $u_M$ wird in der Auswerteeinrichtung 14 mit einem vorbestimmten Schwellwert verglichen. Wird dieser Schwellwert erreicht bzw. überschritten, wird der im Dioden-Modus betriebene RC-IGBT T1 ausgeschaltet, d.h., die Entladung des Gates G des im Dioden-Modus betriebenen RC-IGBT T1 beginnt also mit dem Beginn des Kommutierungsvorgangs.

In der FIG 7 ist eine zweite Ausführungsform der Vorrichtung zur Durchführung des erfindungsgemäßen Kommutierungsverfahrens zweier elektrisch in Reihe geschalteter rückwärts leitfähiger IGBTs T1 und T2 näher dargestellt. Diese zweite Ausführungsform unterscheidet sich von der ersten Ausführungsform dadurch, dass anstelle einer Induktivität 18 ein Stromwandler 22, der nach dem Rogowsky-Spulen-Prinzip aufgebaut ist, verwendet wird. Die Ausgangsspannung eines solchen Stromwandlers 22 ist proportional zur Stromänderung $di/dt$ des Kollektorstroms $i_C$, der durch den im Dioden-Modus betriebenen rückwärts leitfähigen IGBT T12 fließt. Im Diagramm gemäß FIG 8 sind der zeitliche Verlauf des im Dioden-Modus betriebenen rückwärts leitfähigen IGBT T1 fließenden Kollektorstromes $i_C$ und ein zeitlicher Verlauf einer ermittelten Messspannung $u_M$ über der Zeit t aufgetragen. Die Stromkurve $i_C(t)$ entspricht einer Abschaltkennlinie einer Diode. Zum Zeitpunkt $t_M$, an dem sich die Amplitude des Kollektorstromes $i_C$ beginnt zu verringern, weist der Verlauf der Messspannung $u_M(t)$ eine positive Flanke auf. Der Zeitpunkt $t_M$ dieser Flanke wird als Zeitpunkt des Beginns des Stromflusses im IGBT-Modus betriebenen rückwärts leitfähigen IGBT T2 bewertet. Der Zeitpunkt $t_M$ ist der frühestmögliche Zeitpunkte, zu dem der Dioden-Modus betriebene rückwärts leitfähige IGBT T1 abgeschaltet werden kann.

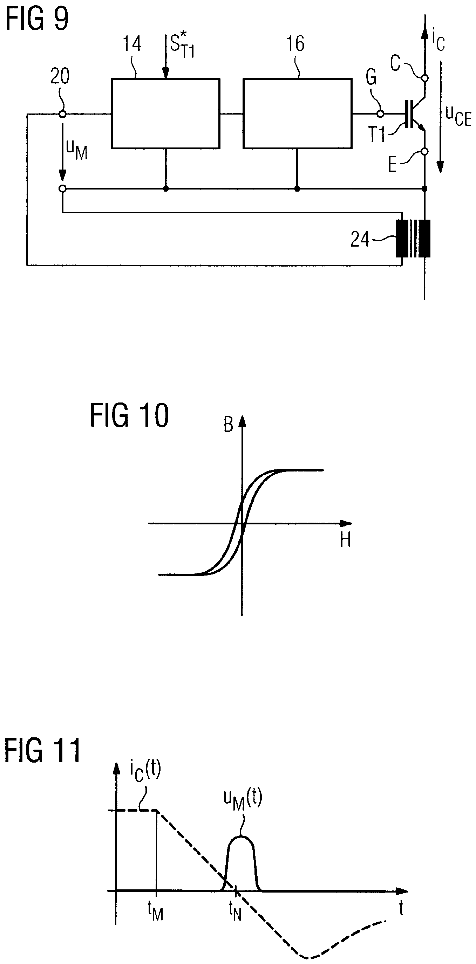

In der FIG 9 ist eine dritte Ausführungsform zur Durchführung des erfindungsgemäßen Kommutierungsverfahren zweier rückwärts leitfähiger IGBTs T1 und T2 näher dargestellt. Diese dritte Ausführungsform unterscheidet sich von der ersten Ausführungsform gemäß FIG 6 dadurch, dass anstelle der Induktivität 18 ein sättigbarer Übertrager 24 vorgesehen ist. In der FIG 10 ist eine Magnetisierungskennlinie dieses sättigbaren Übertragers 24 dargestellt. Diese Magnetisierungskennlinie weist nur einen schmalen linearen Bereich auf. Mittels diesem sättigbaren Übertrager 24 wird nur der Nulldurchgang des Kollektorstromes $i_C$ des im Dioden-Modus betriebenen rückwärts leitfähigen IGBTs T1 ermittelt. Die Erkennung eines Stromnulldurchgangs erfolgt mit dem sättigbaren Übertrager 24 nur dann, wenn sich die magnetische Feldstärke in dem schmalen Bereich der Magnetisierungskennlinie befindet. Genau dann liefert dieser sättigbare Übertrager 24 ein Ausgangssignal, nämlich eine Messspannung $u_M$. Der Verlauf dieser Messspannung $u_M$ ist zusammen mit dem zeitlichen Verlauf des Kollektorstromes $i_C$ des im Dioden-Modus betriebenen RC-IGBT T1 im Diagramm der FIG 11 über der Zeit t dargestellt. Somit wird mit Hilfe des sättigbaren Übertragers 24 der Kommutierungszeitpunkt bei der Kommutierung vom im Dioden-Modus betriebenen RC-IGBT T1 auf den im IGBT-Modus betriebenen RC-IGBT T2 ermittelt. Dieser Zeitpunkt $t_N$ liegt bezüglich des Zeitpunkt $t_M$ zeitlich später. Dadurch wird der im Dioden-Modus betriebene RC-IGBT T1 später abgeschaltet. Dadurch kann die Anodeneffizienz länger reduziert werden, wodurch die Speicherladung sinkt.

Mit diesem erfindungsgemäßen Verfahren kann der Zeitpunkt für die Abschaltung des im Dioden-Modus betriebenen RC-IGBT T1 zweier elektrisch in Reihe geschalteter RC-IGBTs T1 und T2 sehr nah am Zeitpunkt t4, an dem der im IGBT-Modus betriebene rückwärts leitfähige IGBT T2 dieser in Reihe geschalteter RC-IGBTs T1 und T2 eingeschaltet wird, gelegen werden, wodurch die Anodeneffizenz-Absenkung lange wirksam ist. Da dieses erfindungsgemäße Verfahren ereignisgesteuert ist, erfordert es nicht wie beim bekannten zeitgesteuertem Kommutierungsverfahren keine hohe zeitliche Präzision.

**Patentansprüche**

1. Verfahren zur Kommutierung von einem im Dioden-Modus betriebenen rückwärts leitfähigen IGBT (T1) auf einen im IGBT-Modus betriebenen rückwärts leitfähigen IGBT (T2), die eine Stromrichterphase bilden und elektrisch parallel zu einer Gleichspannungsquelle (4) geschaltet sind, mit folgenden Verfahrensschritten:

   a) Einschalten des im Dioden-Modus betriebenen IGBT (T1) nach Ablauf einer vorbestimmten Zeitspanne ($\Delta T_1$) nachdem ein Steuersignal $(S_{T1}^*)$ dieses IGBTs (T1) in einem Aus-Status gewechselt hat,
   b) Einschalten des im IGBT-Modus betriebenen IGBT (T2) nach Ablauf einer vorbestimmten Zeitspanne ($\Delta T_3$) nach dem ein Steuersignal $(S_{T2}^*)$ dieses IGBTs (T2) in einem Ein-Status gewechselt hat, wobei diese Zeitspanne ($\Delta T_3$) größer ist als die Zeitspanne ($\Delta T_1$) des im Dioden-Modus betriebenen IGBTs (T1),
   c) Abschalten des im Dioden-Modus betriebenen IGBT (T1) bevor der im IGBT-Modus betriebene IGBT (T2) einschaltet,

   **dadurch gekennzeichnet, dass** der im Dioden-Modus betriebene IGBT (T1) erst dann abgeschaltet wird, sobald ein Strom im im IGBT-Modus betriebenen rückwärts leitfähigen IGBT (T2) zu fließen beginnt.

2. Verfahren nach Anspruch 1, **dadurch gekennzeichnet, dass** der Beginn des Stromflusses im im IGBT-Modus betriebenen rückwärts leitfähigen IGBT (T2) durch eine Stromänderung eines im im Dioden-Modus betriebenen rückwärts leitfähigen IGBT (T1) fließenden Kollektorstromes ($i_C$) ermittelt wird.

3. Verfahren nach Anspruch 2, **dadurch gekennzeichnet, dass** die Stormänderung eines im im Dioden-Modus betriebenen rückwärts leitfähigen IGBT (T1) mittels einer an einer im Kommutierungskreis befindlichen Induktivität (18) abfallenden Spannung ($u_M$) bestimmt wird.

4. Verfahren nach Anspruch 1, **dadurch gekennzeichnet, dass** ein durch den im Dioden-Modus betriebenen rückwärts leitfähigen IGBT (T1) fließender Kollektorstrom ($i_C$) gemessen und ausgewertet wird.

5. Verfahren nach Anspruch 4, **dadurch gekenn-**

**zeichnet, dass** der gemessene Kollektorstrom ($i_C$) durch den im Dioden-Modus betriebenen rückwärts leitfähigen IGBT (T1) auf Stromnulldurchgang ausgewertet wird.

6. Vorrichtung zur Durchführung des Verfahrens nach einem der Ansprüche 1 bis 5, mit rückwärts leitfähigen IGBTs (T1,T2) einer Stromrichterphase, die elektrisch parallel zu einer Gleichspannungsquelle (4) geschaltet ist und wobei jeder rückwärtsleitfähige IGBT (T1,T2) mit einer Treiberschaltung (16) versehen ist, die jeweils ausgangsseitig mit einem Gate und einem Emitteranschluss (G,E) eines IGBTs (T1, T2) verknüpft sind, **dadurch gekennzeichnet, dass** eine Ansteuereinrichtung (14) und eine Einrichtung zur Erfassung eines Kollektorstromes ($i_C$) vorgesehen sind, wobei diese Auswerteeinrichtung (14) ausgangsseitig mit einem Eingang der Treiberschaltung (16) und eingangsseitig mit Ausgangsanschlüssen (20,E) dieser Einrichtung verknüpft sind und wobei jede Auswerteeinrichtung (14) mit einem zum zugehörigen rückwärts leitfähigen IGBT (T1,T2) korrespondierenden Steuersignal ($S_{T1}^*$, $S_{T2}^*$) versehen ist.

7. Vorrichtung nach Anspruch 6, **dadurch gekennzeichnet, dass** die Einrichtung zur Erfassung eines Kollektorstromes ($i_C$) eine Induktivität (18) ist.

8. Vorrichtung nach Anspruch 6, **dadurch gekennzeichnet, dass** die Einrichtung zur Erfassung eines Kollektorstromes ($i_C$) ein nach dem Rogowsky-Spulen-Prinzip aufgebauter Stromwandler (22) ist.

9. Vorrichtung nach Anspruch 6, **dadurch gekennzeichnet, dass** die Einrichtung zur Erfassung eines Kollektorstromes ($i_C$) ein sättigbarer Übertrager (24) ist.

**Claims**

1. Method for commutating from a reverse-conducting IGBT (T1) operated in the diode mode to a reverse-conducting IGBT (T2) operated in the IGBT mode which form a power converter phase and are electrically connected in parallel with a direct-current voltage source (4), said method comprising the following steps of:

 a) turning on the IGBT (T1) operated in the diode mode after a predetermined time period ($\Delta T_1$) has elapsed since a control signal ($S_{T1}^*$) of said IGBT (T1) has switched to an off-state,
 b) turning on the IGBT (T2) operated in the IGBT mode after a predetermined time period ($\Delta T_3$) has elapsed since a control signal ($S_{T2}^*$) of said IGBT (T2) has switched to an on-state, wherein said time period ($\Delta T_3$) is greater than the time period ($\Delta T_1$) of the IGBT (T1) operated in the diode mode,
 c) turning off the IGBT (T1) operated in the diode mode before the IGBT (T2) operated in the IGBT mode turns on,

 **characterised in that** the IGBT (T1) operated in the diode mode is turned off only at the instant a current starts to flow in the reverse-conducting IGBT (T2) operated in the IGBT mode.

2. Method according to claim 1, **characterised in that** the start of the current flow in the reverse-conducting IGBT (T2) operated in the IGBT mode is determined by means of a current change in a collector current ($i_C$) flowing through the reverse-conducting IGBT (T1) operated in the diode mode.

3. Method according to claim 2, **characterised in that** the current change of a reverse-conducting IGBT (T1) operated in the diode mode is determined by means of a voltage ($u_M$) dropping at an inductor (18) arranged in the commutation circuit.

4. Method according to claim 1, **characterised in that** a collector current ($i_C$) flowing through the reverse-conducting IGBT (T1) operated in the diode mode is measured and evaluated.

5. Method according to claim 4, **characterised in that** the measured collector current ($i_C$) through the reverse-conducting IGBT (T1) operated in the diode mode is evaluated for current zero crossing.

6. Apparatus for performing the method according to one of claims 1 to 5, comprising reverse-conducting IGBTs (T1,T2) of a power converter phase which are electrically connected in parallel with a direct-current voltage source (4) and wherein each reverse-conducting IGBT (T1,T2) is provided with a driver circuit (16), each of which is linked on the output side to a gate and an emitter terminal (G,E) of an IGBT (T1, T2), **characterised in that** an evaluation device (14) and a device for detecting a collector current ($i_C$) are provided, wherein said evaluation device (14) is linked on the output side to an input of the driver circuit (16) and on the input side to output terminals (20,E) of said device and wherein each evaluation device (14) is provided with a control signal ($S_{T1}^*$, $S_{T2}^*$) corresponding to the associated reverse-conducting IGBT (T1,T2).

7. Apparatus according to claim 6, **characterised in that** the device for detecting a collector current ($i_C$) is an inductor (18).

8. Apparatus according to claim 6, **characterised in that** the device for detecting a collector current ($i_C$) is a current transformer (22) constructed according to the Rogowsky coil principle.

9. Apparatus according to claim 6, **characterised in that** the device for detecting a collector current ($i_C$) is a saturable transformer (24).

**Revendications**

1. Procédé de commutation d'un IGBT (T1) à conduction inverse, fonctionnant en mode diode, à un IGBT (T2) à conduction inverse, fonctionnant en mode IGBT, qui forment une phase de convertisseur et qui sont montés en parallèle électriquement à une source (4) de tension continue, comprenant les stades de procédé suivants :

   a) mise en circuit de l'IGBT (T1) fonctionnant en mode diode, après écoulement d'un laps de temps ($\Delta T_1$) défini à l'avance, après qu'un signal ($S^*_{T1}$) de commande de cet IGBT (T1) a passé dans un état arrêt,
   b) mise en circuit de l'IGBT (T2) fonctionnant en mode IGBT, après écoulement d'un laps de temps ($\Delta T_3$) défini à l'avance, après qu'un signal ($S^*_{T2}$) de commande de cet IGBT (T2) a passé dans un état marche, ce laps de temps ($\Delta T_3$) étant plus grand que le laps de temps ($\Delta T_1$) de l'IGBT (T1), fonctionnant en mode diode,
   c) mise hors circuit de l'IGBT (T1) fonctionnant en mode diode, avant de mettre en circuit l'IGBT (T2), fonctionnant en mode IGBT,

   **caractérisé en ce que** l'IGBT (T1) fonctionnant en mode diode n'est mis hors circuit que dès qu'un courant commence à passer dans l'IGBT (T2) à conduction inverse fonctionnant en mode IGBT.

2. Procédé suivant la revendication 1, **caractérisé en ce que** l'on détermine le début du flux de courant dans l'IGBT (T2) à conduction inverse fonctionnant en mode IGBT, par une variation d'un courant ($i_C$) de collecteur passant dans l'IGBT (T1) à conduction inverse fonctionnant en mode diode.

3. Procédé suivant la revendication 2, **caractérisé en ce que** l'on détermine la variation de courant d'un IGBT (T1) à conduction inverse fonctionnant en mode diode, au moyen d'une tension ($u_M$) chutant aux bornes d'une inductance (18) se trouvant dans le circuit de commutation.

4. Procédé suivant la revendication 1, **caractérisé en ce que** l'on mesure et l'on exploite un courant ($i_C$) de collecteur passant dans l'IGBT (T1) à conduction inverse fonctionnant en mode diode.

5. Procédé suivant la revendication 4, **caractérisé en ce que** l'on exploite le courant ($i_C$) de collecteur mesuré dans l'IGBT (T1) à conduction inverse fonctionnant en mode diode jusqu'à un passage par zéro du courant.

6. Système pour effectuer le procédé suivant l'une des revendications 1 à 5, comprenant des IGBT (T1, T2) à conduction inverse d'une phase de convertisseur, qui est monté électriquement en parallèle avec une source (4) de tension continue et dans lequel chaque IGBT (T1, T2) à conduction inverse est pourvu d'un circuit (16) d'attaque, qui, chacun, sont combinés, du côté de la sortie, à une grille et à une borne (G, E) d'émetteur d'un IGBT (T1, T2), **caractérisé en ce qu'**il est prévu un dispositif (14) d'exploitation et un dispositif de détection d'un courant ($i_C$) de collecteur, ce dispositif (14) d'exploitation étant combiné, du côté de la sortie, à une entrée du circuit (16) d'attaque, et du côté de l'entrée, à des bornes (20, E) de sortie de ce dispositif et chaque dispositif (14) d'exploitation est pourvu d'un signal ($S^*_{T1}$, $S^*_{T2}$) de commande correspondant à l'IGBT (T1, T2) à conduction inverse associé.

7. Système suivant la revendication 6, **caractérisé en ce que** le dispositif de détection d'un courant ($i_C$) de collecteur est une inductance (18).

8. Système suivant la revendication 6, **caractérisé en ce que** le dispositif de détection d'un courant ($i_C$) de collecteur est un transformateur (22) de courant formé suivant le principe de la bobine de Rogowsky.

9. Système suivant la revendication 6, **caractérisé en ce que** le dispositif de transmission d'un courant ($i_C$) de collecteur est un transducteur (24) saturable.

## FIG 1

FIG 2

$S^*_{T1}$

ein

aus

t1    t2        t3   t4        t

FIG 3

$S^*_{T2}$

ein

aus

t1   t2         t3   t4        t

FIG 4

$T1_{Sch}$

ein

aus

t1  t2          t3   t4        t

FIG 5

$T2_{Sch}$

ein

aus

t1  t2          t3  t4         t

$\Delta T_1$    $\Delta T_2$    $\Delta T_R$

$\Delta T_3$

## FIG 6

## FIG 7

## FIG 8

# FIG 9

# FIG 10

# FIG 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **M. RAHIMO ; U. SCHLAPBACH ; A. KOPTA ; J. VOBECKY ; D. SCHNEIDER ; A. BASCHNAGEL.** A High Current 3300V Module Employing Reverse Conducting IGBTs Setting a New Benchmark in Output Power Capability. *ISPSD,* 2008